# FASCICULE DE BREVET EUROPEEN

(11) **EP 2 461 277 B1**
(45) Date de publication et mention de la délivrance du brevet: **24.07.2019**
(21) Numéro de dépôt: 11191349.7
(22) Date de dépôt: 30.11.2011
(51) Int. Cl.: G06K 19/077

(54) **Procédé de fabrication d'un dispositif à microcircuit**
Herstellungsverfahren einer Chip Vorrichtung
Method for manufacturing a chip device

(30) Priorité: 06.12.2010 FR 1060110
(43) Date de publication de la demande: 06.06.2012
(73) Titulaire: IDEMIA France, 92700 Colombes (FR)
(72) Inventeur: Bosquet, Olivier, 92000 Nanterre (FR); Boschet, Jean-François, 92000 Nanterre (FR)
(74) Mandataire: Delumeau, François Guy

(56) Documents cités:
- EP-A1- 0 344 058
- EP-A1- 0 456 323
- FR-A1- 2 779 851
- FR-A1- 2 794 266

## Description

La présente invention concerne le domaine technique des dispositifs électroniques portables à microcircuit, tels que notamment les cartes à microcircuit.

Elle s'applique plus particulièrement mais non exclusivement aux cartes à microcircuit de type à contact, dites également plus généralement cartes à puce, dont le format est conforme au format ID-1 défini par la norme ISO-7816.

Une telle carte à puce comprend généralement un corps réalisé dans une matière plastique et muni d'une cavité de réception d'un module à microcircuit, le module étant fixé au corps par exemple par collage.

Il existe actuellement un besoin de réaliser des cartes, notamment des cartes à puce, en papier ou en carton. En effet, un tel matériau présente de nombreux avantages : d'une part, il est recyclable voire même biodégradable et, d'autre part, son coût est généralement inférieur au coût des plastiques conventionnels que sont le PVC ou le PVC ABS, classiquement utilisés dans le domaine. En outre, l'utilisation de matériaux fibreux présente l'avantage de réduire le dégagement d'acide chlorhydrique lors du recyclage des supports formant le corps de carte.

Toutefois, l'utilisation de cartes en papier présente certains inconvénients. La nature du support relativement poreuse des matériaux fibreux en comparaison avec celle des matériaux plastiques rend la carte généralement plus sensible aux efforts de compression.

FR2779851 enseigne d'utiliser un support adhésif pour réduire le coût des matériaux et celui des opérations d'assemblage.

FR 2794266 enseigne d'utiliser un film adhésif pour isoler la puce.

Avant d'être commercialisée, une carte doit subir un certain nombre de tests de résistance mécanique, notamment à la compression. Lors de la réalisation de ces tests sur les cartes en papier, il a été constaté que l'effort subi par la carte est tel que le papier s'écrase et ne peut contenir le fléchissement important du module. Or, lorsque le fléchissement du module est trop important,
le microcircuit porté par le module est susceptible d'être endommagé, voire rendu inopérant.

Il en résulte qu'à l'issue de ces tests, un grand nombre de cartes à microcircuit sont considérées comme défectueuses et doivent être finalement rejetées lors de leur fabrication, ce qui représente un coût non négligeable.

L'invention a notamment pour but de remédier à cet inconvénient en proposant un procédé de fabrication d'une carte à microcircuit, notamment réalisée dans un matériau fibreux tel que du papier ou du carton, permettant d'améliorer la fiabilité de la carte et la résistance mécanique aux tests de solidité de la carte, avec une grande simplicité de mise en oeuvre.

A cet effet, l'invention a notamment pour objet un procédé de fabrication d'un dispositif à microcircuit comprenant un corps muni d'une cavité, dimensionnée pour recevoir un module à microcircuit, la cavité comprenant un fond et une paroi périphérique entourant le fond, le procédé comprenant une étape de mise en place du module dans la cavité, le procédé comprenant avant l'étape de mise en place du module, une étape de dépôt d'une bande adhésive au moins sur une surface du module destinée à être en regard du fond de la cavité, la bande adhésive étant apte à permettre l'adhérence du module au moins au fond de la cavité et à limiter une course de déformation du module susceptible de se produire sous l'effet d'un effort mécanique de compression du module contre le fond de la cavité,
la bande adhésive étant activable sous l'effet de la chaleur, le procédé comprenant en outre une étape de préchauffage de la cavité avant l'étape de mise en place du module.

Grâce à l'invention, la bande adhésive permet l'adhérence du module au corps tout en formant une interface d'absorption d'une déformation du module lorsque ce dernier est soumis à une force de compression contre le fond de la cavité. Par cette action mécanique d'absorption, le module est préservé d'un fléchissement trop important qui pourrait provoquer sa destruction.

Selon une réalisation particulière de l'invention, le corps du dispositif est réalisé dans une matière fibreuse, telle que du papier ou bien du carton.

La bande adhésive étant activable sous l'effet de la chaleur, le procédé comprend une étape de préchauffage de la cavité avant l'étape de mise en place du module. Ceci permet de faciliter l'adhésion de la bande à la cavité sans provoquer un échauffement excessif du micromodule. Ce dernier est alors préservé d'un stress thermique.

Dans un mode de réalisation préféré de l'invention, la bande adhésive étant activable sous l'effet de la chaleur, le procédé comprend une étape de chauffage de la bande et du module pour permettre l'adhérence de la bande sur la surface du module.

De préférence, le module délimitant une surface interne tournée vers la cavité et une surface externe tournée vers l'extérieur de la cavité, on dépose la bande adhésive de manière à ce qu'elle recouvre sensiblement toute la surface interne du module. Ainsi, la bande forme une interface d'absorption efficace sur toute la surface du module.

Dans un mode de réalisation préféré, la paroi périphérique comprenant un gradin délimitant une surface d'appui du module, une fois le module mise en place, la bande adhésive s'étend au moins partiellement sur la surface d'appui.

Dans un mode de réalisation préféré, le procédé comprend une étape de fixation d'une partie centrale du module par pressage à froid et une étape de fixation d'une partie périphérique du module par pressage à chaud. Ceci permet d'éviter de cumuler des contraintes thermique et mécanique de compression au centre du module ce qui pourrait avoir pour effet d'endommager ce dernier. De préférence, l'étape de pressage à chaud précède l'étape de pressage à froid.

Dans un mode de réalisation préféré, l'étape de fixation par pressage à chaud consiste à appliquer une compression en périphérie du module au moyen d'une plaque de pressage évidée.

### BREVE DESCRIPTION DES FIGURES

D'autres caractéristiques et avantages de l'invention apparaîtront à la lumière de la description qui suit, faite en référence aux dessins annexés dans lesquels :
- la figure 1 représente une carte à microcircuit selon l'invention ;
- la figure 2 représente une vue en coupe de la carte selon la ligne 2-2 de la figure 1 ;
- la figure 3 représente une vue de la carte de la figure 1 au cours d'une étape de test ;
- les figures 4 à 7 illustrent des étapes de fabrication de la carte de la figure 1.

### DESCRIPTION DETAILLEE D'UN MODE DE REALISATION PREFERE DE L'INVENTION.

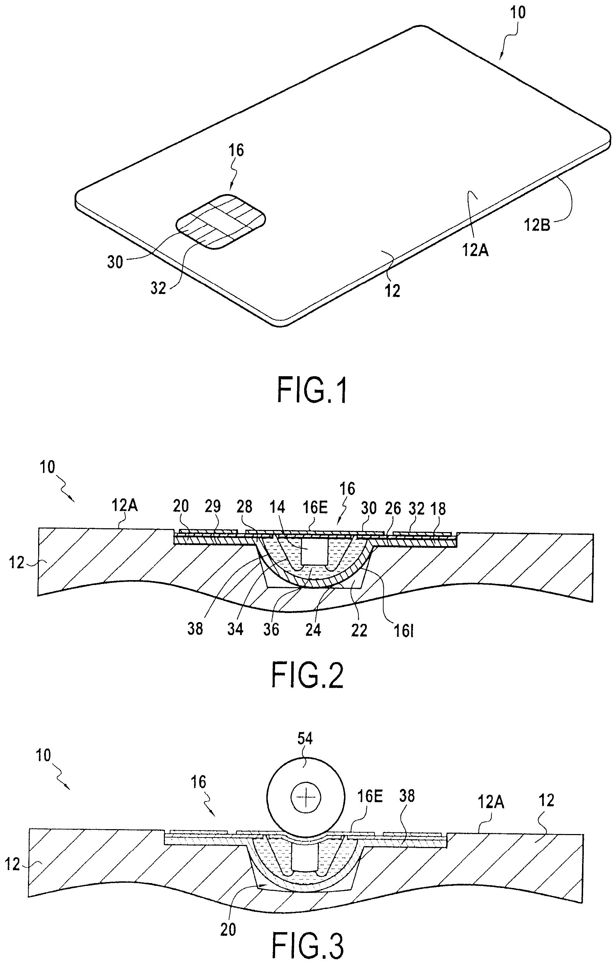

On a représenté sur **la** **figure 1** un dispositif à microcircuit selon l'invention. Ce dispositif est désigné par la référence générale 10.

Dans l'exemple décrit, le dispositif à microcircuit 10 est une carte à microcircuit. En variante, le dispositif 10 peut être une page d'un passeport telle que la couverture du passeport ou encore une étiquette autocollante telle qu'un « sticker ».

Comme cela est illustré sur **la** **figure 1****,** le dispositif 10 comprend un corps 12 en forme générale de carte délimitant des première 12A et deuxième 12B faces opposées.

Dans ce mode de réalisation, le corps 12 délimite les dimensions extérieures de la carte 10. Dans cet exemple et de préférence, les dimensions de la carte 10 sont définies par le format ID-1 de la norme ISO 7816, qui est le format classiquement utilisé pour les cartes bancaires, de dimensions 85.6 mm par 53.98 mm et d'épaisseur sensiblement égale à huit cent micromètres. Bien entendu, d'autres formats de cartes peuvent également être utilisés.

De préférence, le corps de carte 12 est réalisé dans un matériau fibreux, par exemple à base de fibres naturelles et/ou synthétiques. Par exemple, le corps est réalisé en carton ou en papier.

De façon classique, le dispositif 10 comprend un microcircuit 14 apte à échanger avec un terminal externe, à traiter et/ou à mémoriser des données. Conformément à l'invention, le corps 12 incorpore un module à microcircuit 16 comportant le microcircuit 14.

Dans l'exemple décrit, le module 16 comprend un support 18 portant le microcircuit 14. Ainsi, comme cela est illustré sur **la** **figure 2****,** le support 18 délimite des première 18A et deuxième 18B faces opposées, dites respectivement face externe et face interne, la face externe 18A étant tournée vers l'extérieur de la carte 10.

Le support 18 est par exemple réalisé en fibres de verre de type époxy, en polyester ou bien en papier et a une épaisseur comprise par exemple entre cinquante et deux cent micromètres. Dans une solution alternative, le support 18 peut être réalisé dans une matière plastique à base essentiellement de polyimide avec une épaisseur d'environ soixante-dix micromètres.

En outre, dans cet exemple, comme cela est illustré par **la** **figure 2****,** le corps 12 comprend une cavité 20 de logement du module 16. Cette cavité 20 est de préférence ménagée dans le corps 12 et débouche sur une des faces 12A du corps 12, par exemple la première face 12A.

Comme cela est illustré sur **la** **figure 2****,** la cavité 20 comprend par exemple une zone centrale profonde 22 munie d'un fond 24 pour le logement du microcircuit 14 et une zone périphérique surélevée 26 par rapport à la zone centrale 24 délimitant un gradin 28 avec le fond 24. Cette zone périphérique 26 comprend une surface d'appui surélevée 29 par rapport au fond 24 de la cavité 20 sur laquelle reposent les bords du support 18 du module 16.

Une telle cavité 20 est généralement obtenue par usinage, typiquement par fraisage ou lamage en deux opérations :
- un grand lamage pour former la zone périphérique 26 correspondant à la profondeur du gradin 28,
- un petit lamage pour former la zone centrale plus profonde 22.

Afin de communiquer avec un terminal externe, la carte 10 comprend par exemple une interface externe 30 de plages de contact 32 raccordée électriquement au microcircuit 14. Cette interface 30 permet l'établissement d'une communication avec contact de la carte 10 avec un autre terminal externe, par exemple lorsque la carte 10 est insérée dans un lecteur de carte adapté.

Dans l'exemple décrit, l'interface 30 comprend une série de plages métalliques de contacts électriques 32, conformes à une norme prédéfinie de carte à microcircuit. Par exemple, les plages de contacts sont conformes à la norme ISO 7816. L'interface 30 de la carte 10 est de préférence réalisée dans une couche d'un matériau métallique tel que du cuivre mais peut également être réalisée, en variante, par sérigraphie d'encre électriquement conductrice de type encre époxy chargée de particules d'argent ou d'or ou par sérigraphie d'un polymère électriquement conducteur.

De façon classique, les plages 32 sont raccordées électriquement au microcircuit 14 par des fils électriquement conducteurs tels que par exemple des fils d'or traversant des puits ménagés dans le support 18 du module 16.

Par exemple, comme cela est illustré sur **la** **figure 2****,** dans ce mode de réalisation, le microcircuit 14 est monté selon un procédé d'assemblage désigné couramment par « wire bonding » selon la terminologie anglo-saxonne. Selon ce procédé d'assemblage, le microcircuit 14 est monté de manière à ce que sa face passive soit disposée en regard du support 18 du module 16.

Dans ce cas, des fils électriquement conducteurs 34 relient la face active de la puce ou du microcircuit aux éléments conducteurs appropriés du support (tels que des pistes électriquement conductrices formant des extrémités de l'antenne). De préférence, et comme cela est illustré sur **la** **figure 2****,** le microcircuit 14 et les fils 34 sont encapsulés dans une calotte de résine polymère 36.

Dans une variante non illustrée sur les figures, la puce 14 peut être assemblée selon un autre procédé d'assemblage, tel que par exemple un procédé de report de puce de type monté-retourné de l'anglais « flip-chip ». Dans ce cas et contrairement au procédé de « wire bonding », la face active du microcircuit est montée en regard du support par l'intermédiaire de contacts du microcircuit sous forme de billes ou de bosses métalliques et d'une colle électriquement conductrice. La puce est montée-retournée lors du montage de manière à ce que les billes ou les bosses soient soudées aux éléments conducteurs du support de module.

Dans l'exemple décrit, le support 18 ainsi que le microcircuit 14 forment ensemble le module 16. Le module 16 est délimité de préférence par une surface interne 16I et une surface externe 16E.

Afin de fixer le module 16 dans la cavité 20, le dispositif 10 comprend une bande adhésive 38 agencée entre le module 16 et au moins le fond 24 de la cavité 20. Conformément à l'invention, cette bande 38 est apte à limiter une course de déformation du module 16 susceptible de se produire sous l'effet d'un effort mécanique de compression du module 16 contre le fond 24 de la cavité 20.

Comme cela est illustré sur **la** **figure 2****,** de préférence, la bande 38 est disposée sur la surface interne 16I du module 16 tournée vers l'intérieur de la cavité 20 pour recouvrir sensiblement toute la surface interne 16I du module 16. Ceci présente l'avantage d'optimiser la surface de collage du module 16 dans la cavité 20.

Dans l'exemple décrit, la surface interne 16I du module 16 présente un profil en forme de dôme. En outre, dans l'exemple décrit, la surface externe 16E est sensiblement plane et porte l'interface 30 de plages de contact 32.

La bande 38 est en contact permanent avec le fond 24 de la cavité 20. La bande 38 est également fixée au fond 24 de la cavité 20. La bande 38 est formée dans un matériau élastiquement déformable. En outre, le matériau de la bande 38 est un adhésif thermo-activable. L'épaisseur de la bande adhésive 38 est comprise par exemple entre 10 et 100 micromètres et de préférence entre 40 et 60 micromètres. Dans l'exemple décrit, la bande 38 a une épaisseur d'environ 50 micromètres.

De préférence, la bande 38 présente deux faces adhésives, l'une des faces étant appliquée directement sur la surface du module 16. Ainsi, la bande 38 est formée d'une masse de matériau adhésive désignée couramment par l'expression « transfert d'adhésif » et est réalisée par exemple dans un matériau comprenant essentiellement du copolyamide, du polyester, etc.

Dans ce mode de réalisation de l'invention, la bande 38 est déposée, sur la surface interne 16I du module 16, afin de recouvrir sensiblement toute la surface interne 16I.

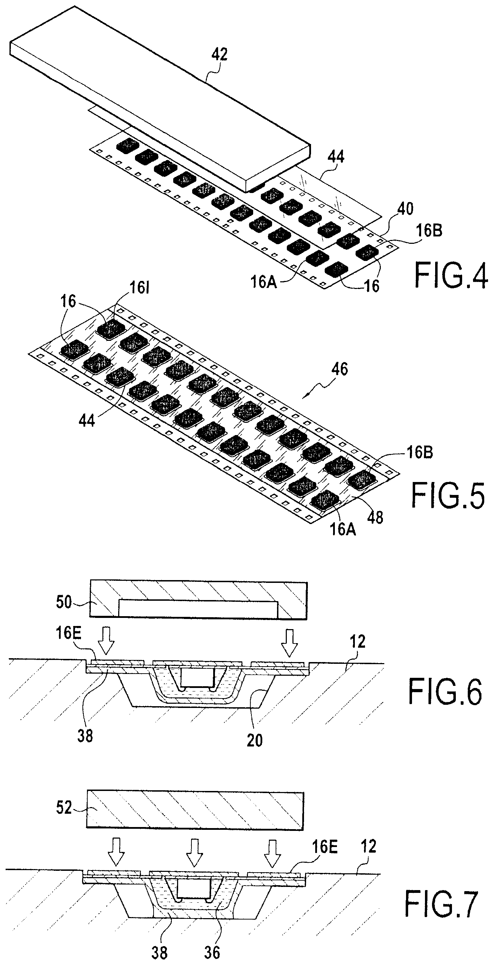

On va maintenant décrire en référence aux **figures 4 à 7** les principales étapes de fabrication du dispositif 10 à microcircuit 14 selon l'invention.

Tout d'abord, le procédé comprend une étape de dépôt de la bande adhésive 38 au moins sur la surface 16I du module 16 destinée à être en regard du fond 24 de la cavité 20.

Initialement, dans cet exemple, un film 40 comportant deux rangées 16A, 16B de micromodules 16 est déroulé pour être mis à plat comme cela est illustré sur **la** **figure 4****.** Pour recouvrir chaque module 16 du film 40 d'une bande adhésive 38, on dépose sur le film 40 une bande adhésive 44 ayant une surface de dimensions correspondant sensiblement aux dimensions du film 40. Ceci permet de recouvrir la surface interne 16I de chaque micromodule 16 du film 40 d'une portion de la bande adhésive 44 correspondant à la bande 38.

Pour faire adhérer la bande adhésive 44 au film 40 de micromodules 16, une plaque de pressage 42 est appliquée contre l'ensemble pour obtenir l'élément 46 représenté sur **la** **figure 5****.** La bande adhésive 44 épouse sensiblement le relief du film 40 ce qui permet d'envelopper chacun des micromodules 16 d'une portion de cette bande 44. Au cours de cette étape, de préférence, comme la bande adhésive 44 est activable sous l'effet de la chaleur, on chauffe la bande 44 et les modules 16 pour permettre l'adhérence de chaque portion de la bande 44 sur la surface interne 16I de chaque module 16.

Puis, au cours d'une étape non illustrée sur les figures, une machine de découpe comportant un organe de poinçonnage découpe une pièce 48 formée par un des micromodules et son enveloppe adhésive formée par la portion de bande 38.

Avant la mise en place du module 16 dans la cavité 20 du corps 12, le procédé comprend une étape de préchauffage de la cavité 20, par exemple à 250°C. Dans ce mode de réalisation, la nature du matériau fibreux du corps de carte 12 supporte de telles températures élevées à la différence d'un support plastique par exemple du type PVC. Le préchauffage est ainsi possible dans ce cas grâce à la nature fibreuse du corps de carte. Ceci permet de faciliter l'adhésion de la bande 38 au corps de carte. De préférence, le module 16 et la bande 38 sont également préchauffés, par exemple à 250°C.

Cette cavité 20 présente dans l'exemple décrit un fond 24 et une paroi périphérique 26 munie d'un gradin 28 délimitant une zone centrale profonde et une zone périphérique surélevée par rapport au fond 24.

Puis, par exemple, la machine comprenant encore un organe de transfert muni de moyens de préhension de type ventouse, l'organe de transfert saisit la pièce par aspiration pour la déplacer dans la cavité 20 du corps de carte 12.

Le procédé comprend encore une étape de fixation du module 16 dans la cavité 20. Dans cet exemple, la fixation du micromodule 16 est réalisée en deux étapes :
- une première étape de pressage à chaud **(****figure 6****)**,
- une deuxième étape de pressage à froid **(****figure 7****)**.

Dans ce mode de réalisation préféré, l'étape à chaud précède l'étape à froid. Ceci permet notamment de mettre à profit le préchauffage de la cavité réalisée précédemment.

La première étape de pressage consiste à appliquer une presse en périphérie du module 16 sur la surface externe 16E du module 16 pour le fixer par exemple au rebord périphérique de la cavité 20 au moyen de la bande 38.

Comme cela est illustré en exemple sur **la** **figure 6****,** au cours de cette première étape de fixation, une plaque de pressage 50 évidée au centre est appliquée contre la surface externe 16E du micromodule 16. Dans l'exemple décrit, au cours de cette étape, cette plaque 50 exerce une force de compression uniquement sur la périphérie de la surface externe 16E du module 16 et non au centre du module 16. L'ensemble est également de préférence chauffé pour provoquer une activation efficace de la masse adhésive 44. Ceci permet de fixer le module 16 au bord de la cavité 20 sans exposer le microcircuit 14 du module 16 à une contrainte thermique conjuguée à un effort de compression.

Au cours de la deuxième étape illustrée par **la** **figure 7****,** une plaque de pressage 52 est appliquée contre notamment le centre de la surface externe 16E pour fixer le module 16 au fond 24 de la cavité 20. Dans ce cas, la plaque de pressage 52 est non évidée ce qui permet d'appliquer une compression notamment sur la partie centrale de la surface externe 16E du module 16 s'étendant sensiblement au droit du microcircuit 14 mais également sur la partie périphérique de cette surface 16E. Du fait que cette étape se déroule à froid, les contraintes exercées sur le microcircuit 14 sont relativement limitées et le microcircuit 14 ne risque pas d'être endommagé par le seul effort de compression. Cette deuxième étape permet de faire adhérer la bande adhésive 38 au fond 24 de la cavité 20. Sous l'effet de la contrainte mécanique, la bande adhésive 38 va venir adhérer au fond de la cavité 20 du corps de carte 12 par déformation.

Eventuellement, de préférence, la variation thermique entre les deux étapes est progressive et non brutale. Par exemple, lors de l'étape de pressage à chaud, on presse trois à quatre fois avec le presseur évidé à des températures décroissantes variant de 170°C à 110° puis on presse au moins une fois à froid avec le presseur plein.

On va maintenant décrire les principaux aspects du fonctionnement du dispositif selon l'invention tel que décrit notamment en référence aux figures précédentes.

Sur **la** **figure 3****,** on a représenté de façon schématique, une étape de test de la résistance mécanique de la carte 10. Ce test est plus précisément désigné par test de la roulette. Une roulette 54 a été représentée de façon schématique sur cette figure.

Lorsque la roulette 54 est appliquée contre le module 16, ce dernier subit une force de compression dirigée vers le fond 24 de la cavité 20. Grâce à l'invention, la bande adhésive 38 permet de contenir la déformation du module 16 et empêche un fléchissement trop important de ce dernier qui pourrait entraîner notamment la destruction du microcircuit.

L'interface 38 qui s'étend entre le fond 24 de la cavité et la surface interne 16I du module 16 permet d'absorber les efforts mécaniques exercés sur le microcircuit et ainsi permettre une déportation de ces contraintes dans la bande adhésive.

Les modes de réalisation qui précèdent ne sont que des exemples possibles de mise en oeuvre de l'invention qui ne s'y limite pas.

## Revendications

1. Procédé de fabrication d'un dispositif (10) à microcircuit (14) comprenant un corps (12) muni d'une cavité (20), dimensionnée pour recevoir un module (16) à microcircuit (14), la cavité (20) comprenant un fond (24) et une paroi périphérique (26) entourant le fond (24), le procédé comprenant une étape de mise en place du module (16) dans la cavité (20), et, le procédé comprenant avant l'étape de mise en place du module (16), une étape de dépôt d'une bande adhésive (38) au moins sur une surface (16I) du module (16) destinée à être en regard du fond (24) de la cavité (20),
la bande adhésive (38) étant apte à permettre l'adhérence du module (16) au moins au fond (24) de la cavité (20) et à limiter une course de déformation du module (16) susceptible de se produire sous l'effet d'un effort mécanique de compression du module contre le fond (24) de la cavité (20),
la bande adhésive (44, 38) étant activable sous l'effet de la chaleur, le procédé comprenant en outre une étape de préchauffage de la cavité (20) avant l'étape de mise en place du module (16).

2. Procédé selon la revendication précédente, dans lequel la bande adhésive (38) étant activable sous l'effet de la chaleur, le procédé comprend une étape de chauffage de la bande (38) et du module (16) pour permettre l'adhérence de la bande (38) sur la surface (16I) du module (16).

3. Procédé selon l'une quelconque des revendications précédentes, dans lequel, le module (16) délimitant une surface interne (16I) tournée vers la cavité (20) et une surface externe (16E) tournée vers l'extérieur de la cavité (20), on dépose la bande adhésive (38) de manière à ce qu'elle recouvre sensiblement toute la surface interne (16I) du module (16).

4. Procédé selon l'une quelconque des revendications précédentes, dans lequel, la paroi périphérique comprenant un gradin (28) délimitant une surface d'appui (29) du module (16), une fois le module (16) mise en place, la bande adhésive (38) s'étend au moins partiellement sur la surface d'appui (29).

5. Procédé selon l'une quelconque des revendications précédentes, dans lequel le procédé comprend une étape de fixation à la cavité d'une partie centrale du module (16) par pressage à froid et une étape de fixation à la cavité d'une partie périphérique du module (16) par pressage à chaud.

6. Procédé selon la revendication précédente, dans lequel l'étape de pressage à chaud précède l'étape de pressage à froid.

7. Procédé selon la revendication 5 ou 6, dans lequel l'étape de fixation par pressage à chaud consiste à appliquer une compression en périphérie du module (16) au moyen d'une plaque (50) de pressage évidée.

## Patentansprüche

1. Verfahren zur Herstellung einer Vorrichtung (10) mit Mikroschaltung (14), umfassend einen Körper (12), der mit einem Hohlraum (20) versehen ist, der dimensioniert ist, um ein Modul (16) mit Mikroschaltung (14) aufzunehmen, wobei der Hohlraum (20) einen Boden (24) und eine Umfangswand (26) aufweist, die den Boden (24) umgibt,
wobei das Verfahren einen Schritt des Anordnens des Moduls (16) in dem Hohlraum (20) aufweist und wobei das Verfahren vor dem Schritt des Anordnens des Moduls (16) einen Schritt des Aufbringens eines Klebebandes (38) mindestens auf einer Fläche (16I) des Moduls (16) aufweist, die dazu bestimmt ist, dem Boden (24) des Hohlraums (20) zugewandt zu sein,
wobei das Klebeband (38) geeignet ist, das Haften des Moduls (16) mindestens am Boden (24) des Hohlraums (20) zu ermöglichen und einen Verformungsweg des Moduls (16) zu begrenzen, der unter der Wirkung einer mechanischen Druckkraft des Moduls gegen den Boden (24) des Hohlraum (20) entstehen kann, wobei das Klebeband (44, 38) unter Wärmeeinwirkung aktivierbar ist, wobei das Verfahren ferner einen Schritt des Vorheizens des Hohlraums (20) vor dem Schritt des Anordnens des Moduls (16) aufweist.

2. Verfahren nach dem vorhergehenden Anspruch, wobei, nachdem das Klebeband (38) unter Wärmeeinwirkung aktivierbar ist, das Verfahren einen Schritt des Aufheizens des Bandes (38) und des Moduls (16) aufweist, um das Haften des Bandes (38) auf der Oberfläche (16I) des Moduls (16) zu ermöglichen.

3. Verfahren nach einem der vorhergehenden Ansprüche, wobei, nachdem das Modul (16) eine innere Oberfläche (16I), die zum Hohlraum (20) zugewandt ist, und eine äußere Oberfläche (16E) begrenzt, die zur Außenseite des Hohlraums (20) zugewandt ist, das Klebeband (38) derart aufgebracht wird, dass es im Wesentlichen die gesamte innere Oberfläche (16I) des Moduls (16) bedeckt.

4. Verfahren nach einem der vorhergehenden Ansprüche, wobei sich, nachdem die Umfangswand eine Abstufung (28) aufweist, die eine Auflagefläche (29) des Moduls (16) begrenzt, das Klebeband (38), sobald das Modul (16) angeordnet worden ist, mindestens teilweise auf der Auflagefläche (29) erstreckt.

5. Verfahren nach einem der vorhergehenden Ansprüche, wobei das Verfahren einen Schritt des Befestigens eines mittleren Teils des Moduls (16) an dem Hohlraum durch Kaltpressen und einen Schritt des Befestigens eines peripheren Teils des Moduls (16) an dem Hohlraum durch Heißpressen aufweist.

6. Verfahren nach dem vorhergehenden Anspruch, wobei der Schritt des Heißpressens dem Schritt des Kaltpressens vorausgeht.

7. Verfahren nach Anspruch 5 oder 6, wobei der Schritt des Befestigens durch Heißpressen darin besteht, eine Kompression am Umfang des Moduls (16) mittels einer vertieften Druckplatte (50) aufzubringen.

## Claims

1. A method for manufacturing a chip (14) device (10) comprising a body (12) provided with a cavity (20), dimensioned to receive a chip (14) module (16), the cavity (20) comprising a bottom (24) and a peripheral wall (26) surrounding the bottom (24),
the method comprising a step for placing the module (16) in the cavity (20), and the method comprising, before the step for placing the module (16), a step for depositing an adhesive strip (38) at least on a surface (161) of the module (16) intended to be opposite the bottom (24) of the cavity (20),
the adhesive strip (38) being able to allow the module (16) to adhere at least to the bottom (24) of the cavity (20) and to limit a deformation travel of the module (16) that may occur under the effect of a mechanical compression force of the module against the bottom (24) of the cavity (20),
the adhesive strip (44, 38) being activatable under the effect of the heat, the method further comprising a step for preheating the cavity (20) before the step for placing the module (16).

2. The method according to the preceding claim, wherein the adhesive strip (38) being activatable under the effect of the heat, the method comprises a step for heating the strip (38) and the module (16) to allow the strip (38) to adhere on the surface (161) of the module (16).

3. The method according to any one of the preceding claims, wherein, the module (16) delimiting an inner surface (161) facing the cavity (20) and an outer surface (16E) facing the outside of the cavity (20), the adhesive strip (38) is deposited such that it covers substantially the entire inner surface (161) of the module (16).

4. The method according to any one of the preceding claims, wherein, the peripheral wall comprising a step (28) delimiting a bearing surface (29) of the module (16), once the module (16) is placed, the adhesive strip (38) extends at least partially over the bearing surface (29).

5. The method according to any one of the preceding claims, wherein the method comprises a step for fastening, to the cavity, a central part of the module (16) by cold-pressing and a step for fastening, to the cavity, a peripheral part of the module (16) by hot-pressing.

6. The method according to the preceding claim, wherein the hot-pressing step precedes the cold-pressing step.

7. The method according to claim 5 or 6, wherein the step for fastening by hot-pressing consists of applying compression at the periphery of the module (16) using a hollowed out pressing plate (50).
